# EUROPEAN PATENT APPLICATION

(11) **EP 1 143 046 A1**
(43) Date of publication of application: **10.10.2001**
(21) Application number: 99972701.9
(22) Date of filing: 19.11.1999
(51) Int. Cl.: C30B 29/06

(54) **SILICON SINGLE CRYSTAL AND PRODUCTION METHOD FOR SILICON SINGLE CRYSTAL WAFER**

(30) Priority: 20.11.1998 JP 33071498; 23.03.1999 JP 7849899
(71) Applicant: Komatsu Denshi Kinzoku Kabushiki Kaisha, Hiratsukashi, Kanagawa 254-0014 (JP)
(72) Inventor: NAKAMURA, Kozo, Komatsu Denshi Kinzoku K.K., Hiratsuka-shi, Kanagawa 254-0014 (JP); SAISHOJI, Toshiaki, Komatsu Denshi Kinzoku K.K., Hiratsuka-shi, Kanagawa 254-0014 (JP); YOKOYAMA, Takashi, Komatsu Denshi Kinzoku K.K., Hiratsuka-shi, Kanagawa 254-0014 (JP); MATSUKUMA, Shin, Komatsu Denshi Kinzoku K.K., Hiratsuka-shi, Kanagawa 254-0014 (JP); ISIKAWA, Fumitaka, Komatsu Denshi Kinzoku K.K., Hiratsuka-shi, Kanagawa 254-0014 (JP)
(74) Representative: Selting, Günther, Dipl.-Ing.
(86) International application number: JP9906478
(87) International publication number: WO0031326

(57) **Abstract**

A method for producing a silicon single crystal by a Czochralski method in order to provide a method capable of affording a wide defect free zone stably to a silicon single crystal wafer produced by a Czochralski method, wherein a ratio G outer/G center of an average value G of an in-crystal temperature gradient in a pulling axis direction within a temperature range, a silicon melting point to 1350 °C, at a crystal outer surface to that at a crystal center is set to 1.10 to 1.50. A method of producing a device wafer suitable for an efficient production, wherein a ratio between an OSF ring inner diameter and a crystal diameter, G1 x G2, and G1 edge/ G1 center are controlled to implement relations, (1.15≤ (G1 edge/G1 center)≤1.25) and (0.5<(OSF ring inner diameter/crystal diameter)<1.06 x (G1 x G2)^{-0.2}), to thereby obtain a silicon single crystal having a gate oxide integrity at C mode yield of at least 60% and being free from dislocation.

## Description

### TECHNICAL FIELD

This invention concerns a method for production of silicon single crystals by the Czochralski method, and in particular concerns a method for production of silicon single crystals in which growth defects are reduced to a level sufficient for practical use, and the economic effect of semiconductor manufacturing processes, up to and including final IC manufacture, can be raised substantially.

This invention further concerns silicon ingots pulled under prescribed conditions by the Czochralski method (CZ method) and silicon single crystal wafers cut from these, as well as production methods for the same.

### BACKGROUND ART

Crystal defects arising during growth of CZ silicon single crystals obtained by the Czochralski method (hereafter "CZ method") have an adverse effect on the reliability of gate oxide film in MOS devices and on PN junction leak characteristics and similar, and so must be reduced insofar as possible.

Representative growth defects contained in CZ silicon single crystals include dislocation clusters, octahedral void defects, and ring-shape oxidation-induced stacking faults (hereafter abbreviated "OSF rings"). It is widely known that void defects degrade the reliability of the gate oxide film of MOS devices, and that dislocation clusters degrade the characteristics of semiconductor devices.

These defects do not occur in a disorderly manner in the CZ silicon single crystal; it is known that on the inside of OSF rings void defects occur, and on the outside dislocation clusters occur.

That is, the silicon ingots obtained by the CZ method and the silicon wafers cut therefrom can be divided into four areas according to the distribution of growth-induced defects: (I) a void defect zone, (II) an OSF ring zone, (III) a perfectly crystalline (defect free) zone, and (IV) a dislocation cluster zone.

It is known that the position of the OSF ring is influenced by the temperature gradient within the crystal in the pulling axis direction (this changes with the position in the crystal radial direction) (E. Dornberger, W. v. Ammon, J. Electrochem. Soc., Vol. 143 (1996), p. 1648). The above "(II) OSF ring zone" is inappropriate for a wafer to be used for devices; and a "(IV) dislocation cluster zone" also is inappropriate for a wafer for devices, since dislocation clusters have an adverse effect on PN junction leak characteristics.

For these reasons, until now "(I) void defect zone" crystals have primarily been used; but recently there has been interest in the production of crystals the entirety of which is occupied by the "(III) perfectly crystalline (defect free) zone" (Journal Jpn. Assoc Crystal Growth, Vol. 25 No. 5 (1998), p. 207).

With respect to production of a perfect crystal, Hourai et al. have shown that in the zone on the outside of an OSF ring there occurs a defect free zone not containing dislocation clusters, and have reported that, by adjusting the relation between the crystal growth speed and the temperature gradient within the crystal in the pulling axis direction such that the ratio is within a special range, defect free single crystals not containing growth defects were obtained (54th Conf. Jpn. Soc. Appl. Phys. (Sept. 27 to 30, 1993); Preprints 54th Conf. Jpn. Soc. Appl. Phys., No. 1, p. 303, 29a-HA-7; Japanese Patent Laid-open No. H8-330316; M. Hourai, H. Nishikawa, T. Tanaka et al., Semiconductor Silicon, 1998, p. 453).

However, the method of Hourai et al. involves adjusting the relation between the crystal growth speed and the temperature gradient in the crystal in the pulling axis direction so as to assume a ratio within a special extremely narrow range, and this control is difficult. As a result of the difficulties of such operation control, the costs incurred tend to be very high, so that even when the economic effect is enhanced through improvement of yield by reduction of growth defects, the economic effect of the entire semiconductor production process declines. And because the behavior of the occurrence of the defect free zone is not clear, it is not possible to reliably obtain, at a definite rate, products containing a sufficient defect free zone, thus it is unstable.

In other words, if it were possible to efficiently grow a crystal consisting only of the "(III) perfectly crystalline (defect free) zone", the problem of degradation of the gate oxide film withstand voltage characteristic due to the existence of void defects would be resolved; but considerably precise pulling control is necessary for production of a perfect crystal, and so production efficiency tends to decline compared with previous cases.

### DISCLOSURE OF THE INVENTION

An object of this invention is to provide a method enabling the stable endowment of silicon single crystal wafers produced by the CZ method with a broad defect free zone.

Another object of this invention is to provide a method for producing wafers for devices, suitable for efficient production.

In order to achieve the above objects, this invention concerns a method for producing a silicon single crystal ingot by the Czochralski method, characterized in that
by adjusting parameters during pulling of the silicon single crystal ingot, and performing pulling of "a silicon single crystal ingot containing a perfectly crystalline part" such that an OSF ring appears at a prescribed position in the silicon single crystal ingot, a production efficiency of "a perfectly crystalline part of the silicon single crystal ingot" and/or of "a part of the silicon single crystal ingot which can be used as wafers" is improved.

Thus in this invention, firstly, even when the fraction of the perfect crystal part in a silicon single crystal ingot is low, by raising the pulling speed, a state can be achieved in which the efficiency of production of the perfect crystal part is in fact improved, when converted into per unit time. Also in this invention, secondly, by appropriately adjusting the position of appearance of the OSF ring, it is possible to create a silicon single crystal ingot in which, although there exist crystal defects, there is a high fraction of the part adequate for use as wafers (the part for which use as wafers is possible). Consequently it is possible to improve the efficiency of production of this part adequate for use as wafers (the part for which use as wafers is possible).

In one aspect of this invention, a method is provided for producing, reliably and at low cost, a broad defect free zone in a silicon single crystal ingot produced by the CZ method, by investigating in detail the behavior of the occurrence of the defect free zone under various growth conditions. Further, a method is provided enabling the stable supply at low cost of high-quality silicon wafers with few growth defects.

A separate aspect of this invention was devised based on the expectation that high-quality silicon wafers can be obtained by expanding the defect free zone on the outside of the OSF ring, taking as a premise the fact shown by Hourai et al. that "a denoded zone not containing dislocation clusters may occur in the zone outside the OSF ring". However, this invention makes possible "the enlargement of the defect free zone outside the OSF ring, and the stable supply at low cost of silicon wafers containing a broad defect free zone," which previously had not been possible due to the fact that the behavior of the occurrence of the defect free zone was not clear and was simultaneously unstable.

Specifically, This invention provides the following methods for production of silicon single crystal ingots and the following silicon single crystal wafers.
(A1) A method for producing a silicon single crystal ingot by the Czochralski method, characterized in that Gₒᵤₜₑᵣ/G_{center}, which is a ratio of values at a crystal outer edge and at a crystal center of an average value G of a temperature gradient in the crystal in a pulling axis direction, within a temperature range from a silicon melting point to 1350°C, is between 1.10 and 1.50. There is no established value for the melting point of silicon, which is said to be between 1412°C and 1420°C; but the temperature in degrees Celsius of the silicon melting point is not addressed as a problem in this invention, and whatever the established value of the silicon melting point may be, "the temperature range from the melting point of silicon to 1350°C" is included in the range of this invention.
(A2) The above-described method for producing a silicon single crystal ingot, characterized in that the silicon single crystal ingot production is performed while adjusting a distance between a silicon melt and a heat-shield member installed in a Czochralski-method silicon single crystal production equipment.
(A3) The above-described method for producing a silicon single crystal ingot, characterized in that, when producing the silicon single crystal ingot, a pulling speed of the silicon single crystal ingot is changed.
(A4) A silicon single crystal wafer, obtained from the above-described silicon single crystal ingot, in which there exists an OSF ring an inner diameter of which is 70% or less of an overall diameter, and in which there exists, surrounding the OSF ring, a defect free zone occupying 50% or more of a total surface area (on one side).
(A5) A silicon single crystal wafer, obtained from the above-described silicon single crystal ingot, wherein there exists an OSF ring an inner diameter of which is 50% or less of an overall diameter, and in which there exists, surrounding the OSF ring, a defect free zone occupying 75% or more of a total surface area (on one side).

As a separate embodiment, in order to achieve the aforementioned objects, these inventors investigated the usefulness of a crystal in which are intermixed the above zones I, II and III, pulling control for which is easier than in the case of a perfect crystal. Conditions were determined enabling the production of such an intermixed-zone crystal in which the gate oxide integrity (GOI) yield is satisfactory and dislocation clusters do not occur, thereby completing this invention.

Until now, the relations between the pulling conditions, the proportions of the above zone I and zone III, and the GOI yield had not been clearly demonstrated (if zone III broadens in the in-plane defect zone distribution, the part with satisfactory of the GOI characteristics broadens, but a tendency for the GOI defect density to increase in the narrowing zone I is observed; and so considering the GOI yield over the entire wafer, it is not necessarily the case that if zone III is increased the high GOI will be strengthened), and so it has been difficult to determine pulling conditions in order to produce a crystal with satisfactory high GOI characteristics. However, it was thought that one effective solution is to produce a crystal in which the above-described zones I, II and III are intermixed, with greater ease of pulling control, rather than a perfect crystal. As a result of detailed studies of conditions, the present invention was completed.

In this process, the inventors discovered that in silicon wafers cut from silicon ingots produced by the CZ method, by expanding the inner diameter of the OSF ring, the, density of void defects in the void defect zone existing therein decreases, making the wafer suitable as a non-annealed silicon wafer (a silicon wafer not subjected to annealing treatment (for example, in Japanese Patent Application Laid-open No. 61-193456)), to complete this invention.

Specifically, this invention provides the following.
(B1) A silicon ingot, pulled by a CZ method under conditions satisfying the following (1) and (2):
   (1) "1.15 ≤ (G1_{edge}/G1_{center}) ≤ 1. 25"
   (2) "0.5 < (OSF ring inner diameter/crystal diameter) < 1.06 x (G1_{center} x G2_{center})^{-0.2}"
(B2) A silicon wafer, cut from the above-described (1) silicon ingot, characterized in that the inner diameter of the OSF ring is at least 1/2 the inner diameter of the wafer.
(B3) A method of producing a silicon ingot, characterized in that the silicon ingot is pulled by the CZ method under conditions satisfying the following (1) and (2):
   (1) "1.15 ≤ (G1_{edge}/G1_{center}) ≤ 1.25"
   (2) "0.5 < (OSF ring inner diameter/crystal diameter) < 1.06 x (G1_{center} x G2_{center})^{-0.2}"
(B4) A silicon wafer for non-annealing, cut from a silicon ingot produced by the CZ method, characterized in that an inner diameter of an OSF ring is at least 1/2 a wafer inner diameter.
(B5) The silicon wafer for non-annealing according to (B4), characterized in that the silicon ingot is produced by pulling under conditions such that "1.15 ≤ (G1_{edge}/G1_{center}) ≤ 1.25".
(B6) In a silicon wafer cut from a silicon ingot produced by the CZ method, a method to reduce a density of void defects existing on the inside of an OSF ring by expanding an inner diameter of the OSF ring.
(B7) In a silicon wafer cut from a silicon ingot produced by the CZ method, a method to improve a GOI in an area on the inside of an OSF ring by controlling a ratio of an OSF ring inner diameter to a crystal diameter, G1xG2, and G1_{edge}/G1_{center}.

### Definitions of Terms and Similar

"G1" signifies the temperature gradient (°C/mm) in the axis direction in the temperature region in which the pattern of defects introduced during growth is determined (the temperature region from the solid-liquid interface temperature to approximately 1350°C). "G2" signifies the axial-direction temperature gradient (°C/mm) of the void defect formation temperature region (the temperature region near 1120°C).

"G1_{center}" denotes the axial-direction temperature gradient (°C/mm) at the crystal center, from the solid-liquid interface temperature to approximately 1350°C; "G1_{edge}" signifies the axial-direction temperature gradient (°C/mm) at the crystal edge, from the solid-liquid interface temperature to approximately 1350°C. "G2_{center}" denotes the axial-direction temperature gradient (°C/mm) at the center of the crystal near 1120°C.

With respect to the conditions "1.15 ≤ (G1_{edge}/G1_{center}) ≤ 1.25" and "0.5 < (OSF ring inner diameter/crystal diameter) < 1.06 x (G1_{center} x G2_{center})^{-0.2}", the values 1.15, 1.25, 0.5, 1.06, and -0.2 which appear here were, as explained below, calculated or determined based on plots obtained from experiments, and are no more than the optimal values as understood by the inventors at this stage. Hence inventions which deviate slightly from the above ranges yet have the same actions and effects as this invention are, in technical terms, equivalent, and so it is reasonable to regard these as contained within the technical scope of this invention.

### Silicon Single Crystal Wafers

The above invention, while accepting the existence of crystal defects, realizes a reduction in the costs required to monitor the conditions for reducing growth defects and enhancement of the economic effect of semiconductor production processes in their entirety. Hence from the standpoint of lowering costs while accepting the existence of crystal defects, the silicon single crystal wafers produced by means of this invention necessarily contain an OSF ring to some extent together with a defect free zone. If the ratio is within the abovedescribed range, then it is contained in the range of this invention.

The silicon single crystal wafer of this invention is cut from a silicon single crystal ingot of this invention, and can be produced by means of prescribed machining according to standard methods.

### Silicon Single Crystal Ingot Production Equipment

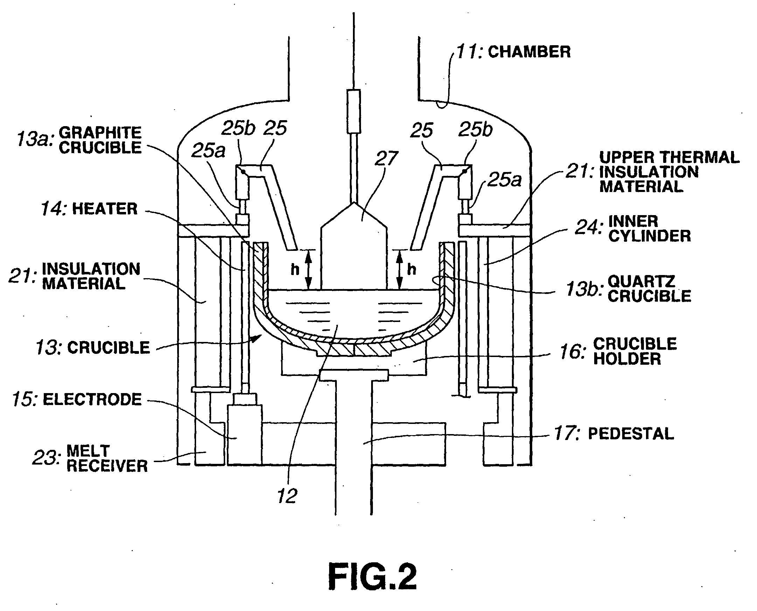

Fig. 2 is a block diagram showing the principal parts of silicon single crystal ingot production equipment of this invention. Similarly to ordinary CZ-method silicon single crystal production equipment, the silicon single crystal ingot production equipment of this invention comprises a crucible 13 for production and storage of silicon melt 12 inside a sealed chamber 11 (as in ordinary CZ-method silicon single crystal production equipment, this crucible 13 comprises a quartz crucible 13b positioned on the inside of a graphite crucible 13a); a heater 14 to heat this crucible 13; an electrode 15 to supply electric power to this heater 14; a crucible holder 16 to support the crucible 13; and a pedestal 17 which rotates the crucible 13. Within the chamber 11 are provided thermal insulation material 21, melt receiver 23, and inner cylinder 24 as appropriate. This equipment also comprises a heat-shield member 25 to shield the radiation of heat from the heater 14 to the bulk silicon 27. Also, though not shown in particular, the silicon single crystal ingot production equipment of this invention also comprises the inert gas introduction and exhaust system with which this type of CZ-method silicon single crystal production equipment is normally equipped. In such a system, the heat-shield member 25 also incorporates a function to adjust the flow path of the inert gas.

Characteristic of the silicon single crystal ingot production equipment of this invention is the fact that the values of V/G (mm²/°C-min) and Gₒᵤₜₑᵣ/G_{center}, which are keys to the execution of this invention, are adjusted by moving the heat-shield member 25 to adjust the distance h from the tip part of the heat-shield member 25 to the liquid surface of the silicon melt 12. In actuality, by adjusting the distance h the amount of heat shielding of the bulk silicon 27 from the heater 14 and the liquid surface of the silicon melt 12 is changed, and simultaneously the quantity and speed of the inert gas flowing over the surface of the bulk silicon 27 are changed slightly; as a result it should be possible to adjust the temperature gradient in the crystal at the surface of the bulk silicon 27 in the crystal pulling axis direction, and therefore also the temperature gradient in the crystal in the center part in the crystal pulling axis direction.

In this aspect, adjustment of the distance h from the tip part of the heat-shield member 25 to the liquid surface of the silicon melt 12 is performed by the linkage of the lifter 25a which adjusts the height of the heat-shield member 25, and the angular 25b which adjusts the inclination of the heat-shield member 25. However, adjustment of the distance h is not limited to this mechanism. That is, insofar as this invention is the first instance of adjustment of the V/G value (mm²/°C-min) and of Gₒᵤₜₑᵣ/G_{center} using the heat-shield member installed in CZ-method silicon single crystal production equipment, any aspect which enables adjustment of the distance h should be construed as being included in the scope of this invention.

In this invention, adjustment of the distance h may for example be performed based on the calculation results of simulation analysis such as a global heat transfer analysis, or may be performed by feedback control based on measured values or by similar means.

### BRIEF DESCRIPTION OF THE DRAWINGS

Fig. 1 is a conceptual view showing the position in the radial direction of the OSF ring and the range of distribution of the defect free zone, resulting from the pulling speed;
Fig. 2 is a block diagram showing the principal parts of silicon single crystal ingot production equipment of this invention; and,
Figs 3(A) to 3(F) are figures showing the GOI results and the presence or absence of dislocation clusters, resulting from the ratio of the OSF ring inner diameter to the crystal diameter and the G1xG2 condition, for Table 1 through Table 6. In particular, Fig. 3(A) is for Table B1, Fig. 3(B) is for Table B2, Fig. 3(C) is for Table B3, Fig. 3(D) is for Table B4, Fig. 3(E) is for Table B5, and Fig. 3(F) is for Table B6.

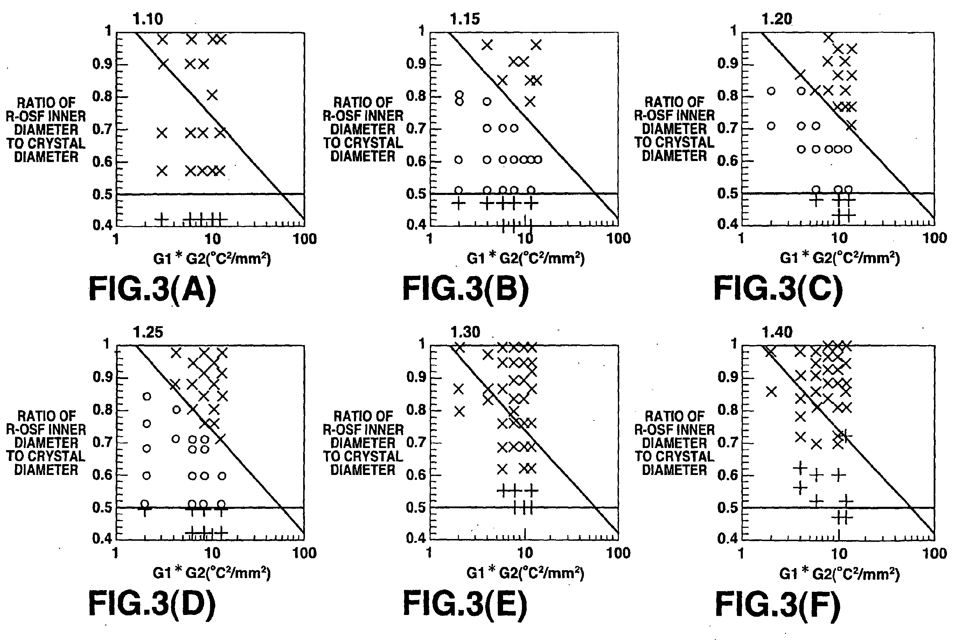

In Figs. 3(A) to 3(F), O denotes an item with a GOI C mode yield of 60% or higher, and with no dislocation clusters; + denotes an item with a GOI C mode yield of 60% or higher, and with dislocation clusters; and × denotes an item with a GOI C mode yield of less than 60%. The numbers in the figures indicate the G1_{edge}/G1_{center} values.

### BEST MODE FOR CARRYING OUT THE INVENTION

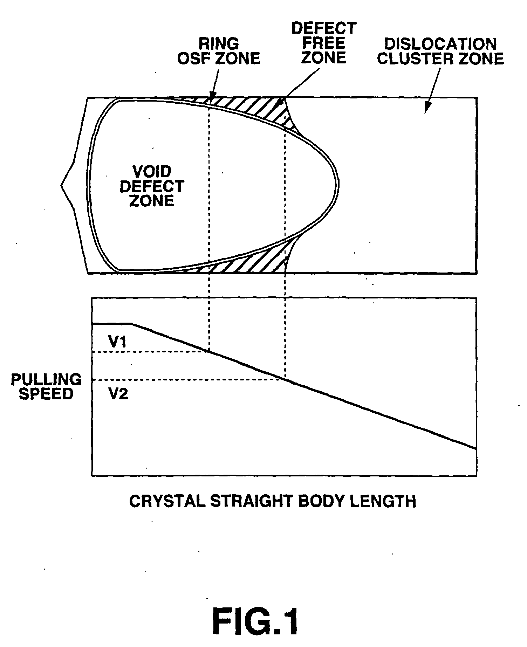

As a result of investigating the behavior of the occurrence of the defect free zone under various growth conditions, it was found that the radial-direction position of the OSF ring and range of distribution of the defect free zone due to the pulling speed are as in Fig. 1. That is, the OSF ring contracts as the pulling speed is decreased, but when the OSF ring radius becomes smaller than a specific value, the defect free zone vanishes. Hence in order to obtain a constant defect free zone, the pulling speed is inappropriate if either too high or too low, but must be within a certain prescribed range which is appropriate (the interval from V1 to V2 in Fig. 1).

As described above, the position of the OSF ring is known to be affected by the temperature gradient in the crystal in the pulling axis direction (which changes with the position in the radial direction of the crystal). Hence studies were conducted to determine the temperature gradient in the crystal in the pulling axis direction, at different positions in the radial direction, for which the defect free zone is obtained over the broadest range. In these studies, because there is a correlation between the pulling speed of the bulk crystal and the temperature gradient in the crystal, experimental results were obtained by investigating the defect distribution when the pulling speed was gradually reduced, as in the example of Fig. 1.

Void defects and dislocation clusters were studied by Secco etching without stirring, and OSF ring positions were evaluated by X-ray topography after oxidation heat treatment for three hours at 780°C, and also after a subsequent 16 hours at 1000°C. The temperature gradient in the crystal in the pulling axis direction at each position in the radial direction was determined from total heat transfer analysis in the growth equipment currently being established. Experiments were conducted using crystals 200 mm in diameter.

### Embodiment 1

Table A1 shows, for each growth condition, the external radius of the smallest OSF ring for which a state in which the defect free zone extends from the OSF ring outer side to the crystal perimeter is maintained, as shown in Fig. 1. Hence in Table 1, a smaller radius signifies that a larger area is occupied by the defect free zone.

From Table A1, it is seen that when the ratio Gₒᵤₜₑᵣ/G_{center} of the values of the average value of G for the temperature gradient in the crystal in the pulling axis direction at the crystal outer face and at the crystal center, in the temperature range from the silicon melting point to 1350°C, is between 1.10 and 1.50, the outer radius of the smallest OSF ring is small (that is, the area occupied by the defect free zone is large). Thus it was found that this range is a preferred growth condition to obtain an appropriate defect free zone fraction. On the other hand, when Gₒᵤₜₑᵣ/G_{center} is not between 1.10 and 1.50, the area of the wafer occupied by the defect free zone falls to less than 1/2, and the effect of endowing a defect free zone is greatly diminished.

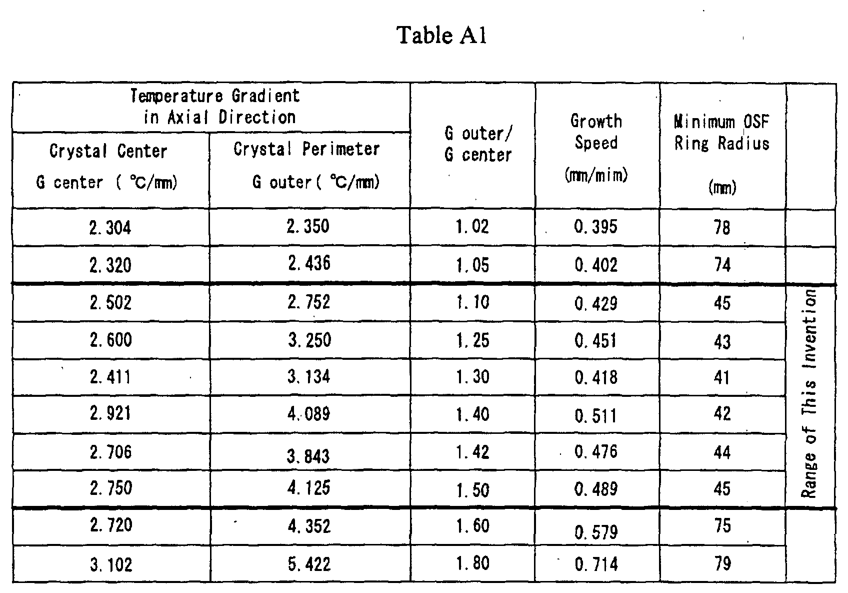

### Embodiment 2

In the growth conditions sought in Table A1, when the crystal is grown at a constant pulling speed, changes in the temperature gradient in the crystal during growth cause a gradual deviation from the optimum growth conditions, so that in some cases the area occupied by the defect free zone contracts (as one example, see Table A2).

**Table A2**

| Crystal Length (mm) | Distance from Si Melt to Heat-Shield Member (mm) | G center (°C/mm) | G outer (°C/mm) | G outer/ G center | Pulling Speed (mm/min) | Minimum OSF Ring Radius (mm) |
|---|---|---|---|---|---|---|
| 0 | 25 | 2.827 | 4.749 | 1.68 | 0.451 | #### |
| 100 | 25 | 2.747 | 4.175 | 1.52 | 0.451 | #### |
| 200 | 25 | 2.690 | 3.954 | 1.47 | 0.451 | 45 |
| 300 | 25 | 2.661 | 3.486 | 1.31 | 0.451 | 41 |
| 400 | 25 | 2.600 | 3.250 | 1.25 | 0.451 | 43 |
| 500 | 25 | 2.549 | 3.161 | 1.24 | 0.451 | 43 |
| 600 | 25 | 2.506 | 3.057 | 1.22 | 0.451 | 45 |
| 700 | 25 | 2.478 | 2.974 | 1.20 | 0.451 | 52 |
| 800 | 25 | 2.433 | 2.871 | 1.18 | 0.451 | 58 |
| 900 | 25 | 2.401 | 2.737 | 1.14 | 0.451 | 64 |
| 1000 | 25 | 2.381 | 2.667 | 1.12 | 0.451 | 67 |
| * ### indicates that the defect free zone did not extend to the crystal perimeter. | | | | | | |

In such a case, by changing the pulling speed according to changes in the crystal length a certain defect free zone can be endowed (Table A3).

**Table A3**

| Crystal Length (mm) | Distance from Si Melt to Heat-Shield Member (mm) | G center (°C/mm) | G outer (°C/mm) | G outer/G center | Pulling Speed (mm/min) | Minimum OSF Ring Radius (mm) |
|---|---|---|---|---|---|---|
| 0 | 25 | 2.827 | 4.749 | 1.68 68 | 0.460 | #### |
| 100 | 25 | 2.747 | 4.175 | 1.52 | 0.459 | 43 |
| 200 | 25 | 2.690 | 3.954 | 1.47 47 | 0.455 | 45 |
| 300 | 25 | 2.661 | 3.486 | 1.31 31 | 0.453 | 41 |
| 400 | 25 | 2.600 | 3.250 | 1.25 | 0.451 | 43 |
| 500 | 25 | 2.549 | 3.161 | 1.24 24 | 0.451 | 43 |
| 600 | 25 | 2.506 | 3.057 | 1.22 | 0.448 | 43 |
| 700 | 25 | 2.478 | 2.974 | 1.20 | 0.445 | 45 |
| 800 | 25 | 2.433 | 2.871 | 1.18 18 | 0.437 | 46 |
| 900 | 25 | 2.401 | 2.737 | 1.14 14 | 0.432 | 47 |
| 1000 | 25 | 2.381 | 2.667 | 1.12 12 | 0.428 | 48 |
| * ### indicates that the defect free zone did not extend to the crystal perimeter. | | | | | | |

### Embodiment 3

An object of this embodiment is to show that when, as in Embodiment 2, there is gradual deviation from the optimum growth conditions due to changes in the temperature gradient in the crystal during growth, by applying changes to the distance between the silicon melt and the heat-shield member, endowment of a constant defect free zone is possible (Table A4).

**Table A4**

| Crystal Length (mm) | Distance from Si Melt to Heat-Shield Member (mm) | G center (°C/mm) | G outer (°C/mm) | G outer/ G center | Pulling Speed (mm/min) | Minimum OSF Ring Radius (mm) |
|---|---|---|---|---|---|---|
| 0 | 25 | 2.827 | 4.749 | 1.68 | 0.451 | #### |
| 100 | 25 | 2.747 | 4.175 | 1.52 | 0.451 | #### |
| 200 | 25 | 2.690 | 3.954 | 1.47 | 0.451 | 45 |
| 300 | 25 | 2.661 | 3.486 | 1.31 | 0.451 | 41 |
| 400 | 25 | 2.600 | 3.250 | 1.25 | 0.451 | 43 |
| 500 | 25 | 2.549 | 3.161 | 1.24 | 0.451 | 43 |
| 600 | 23 | 2.540 | 3.150 | 1.24 | 0.451 | 42 |
| 700 | 21 | 2.531 | 3.063 | 1.21 | 0.451 | 43 |
| 800 | 20 | 2.526 | 3.031 | 1.20 | 0.451 | 43 |
| 900 | 18 | 2.518 | 2.996 | 1.19 | 0.451 | 45 |
| 1000 | 16 | 2.511 | 2.913 | 1.10 | 0.451 | 46 |
| * ### indicates that the defect free zone did not extend to the crystal perimeter. | | | | | | |

As shown in Table A4, under conditions with the pulling speed constant, by changing the distance between the silicon melt and the heat-shield member according to changes in the crystal length, endowment of a constant defect free zone is possible. By means of this Embodiment 3, if the distance between the silicon melt and heat-shield member is changed, the same effect is obtained as when the pulling speed is changed (Embodiment 2). From this, it became clear that from the standpoint of obtaining a constant defect free zone, changing the distance between the silicon melt and the heat-shield member in the silicon single crystal ingot production equipment has an effect equivalent to changing the pulling speed.

### Embodiment 4

Under various hot zone conditions with different temperature environments, the pulling speed was changed, crystals were produced with different fractions of the above-described zones I through IV, and wafers cut from several places in each crystal were used in measurements of the GOI and OSF ring inner diameter (where the inner diameter is zone I) and to confirm the presence or absence of dislocation clusters; by these means, conditions were determined enabling the production of crystals having a satisfactory of the GOI and with no occurrence of dislocation clusters. GOI measurements were performed for an oxide film thickness of 25 nm, with an electrode area of 10 mm². The OSF inner diameter was determined from X-ray topography images after wafer heat treatment, and the presence or absence of dislocation clusters was judged through optical microscope observations after seco-etching.

The results appear in the attached Table B1 through Table B6. The tables list the pulling conditions at each wafer cutting position; pulling speed V, axial-direction temperature gradients at the crystal center G1, G2, G1_{edge}/G1_{center}, G1xG2, the ratio of the OSF ring inner diameter to the crystal diameter, the measured GOI, and the presence of dislocation clusters, organized by the G1_{edge}/G1_{center} condition. In these tables, if the C mode yield for the GOI is 60% or higher, the crystal can be regarded as better than crystals normally in use

**Table B1**

| Table: Pulling conditions results, and presence/absence of dislocation clusters | | | | | | | | | |
|---|---|---|---|---|---|---|---|---|---|
| | G1 °C/mm | G2 °C/mm | V mm/min | G1e /G1c | r(OSF) /r(Crystal) | G1*G2 °C²/mm² | GOI % | Dislocation Clusters Present? | Applicable to Claims |
| Table 1 | 2.0 | 1.5 | 0.33 | 1.1 | 0.977 | 3 | 25.23 | No | |
| | 2.0 | 1.5 | 0.32 | 1.1 | 0.902 | 3 | 35.40 | No | |
| | 2.0 | 1.5 | 0.31 | 1.1 | 0.693 | 3 | 58.40 | No | |
| | 2.0 | 1.5 | 0.3 | 1.1 | 0.580 | 3 | 59.40 | No | |
| | 2.0 | 1.5 | 0.26 | 1.1 | 0.422 | 3 | 72.20 | Yes | |
| | 2.5 | 2.4 | 0.41 | 1.1 | 0.977 | 6 | 11.72 | No | |
| | 2.5 | 2.4 | 0.4 | 1.1 | 0.902 | 6 | 25.54 | No | |
| | 2.5 | 2.4 | 0.39 | 1.1 | 0.693 | 6 | 57.97 | No | |
| | 2.5 | 2.4 | 0.38 | 1.1 | 0.580 | 6 | 58.30 | No | |
| | 2.5 | 2.4 | 0.35 | 1.1 | 0.422 | 6 | 72.20 | Yes | |
| | 3.2 | 2.5 | 0.52 | 1.1 | 0.902 | 8 | 23.19 | No | |
| | 3.2 | 2.5 | 0.5 | 1.1 | 0.693 | 8 | 57.64 | No | |
| | 3.2 | 2.5 | 0.48 | 1.1 | 0.580 | 8 | 58.30 | No | |
| | 3.2 | 2.5 | 0.45 | 1.1 | 0.422 | 8 | 72.20 | Yes | |
| | 3.3 | 3.0 | 0.54 | 1.1 | 0.977 | 10 | 6.16 | No | |
| | 3.3 | 3.0 | 0.52 | 1.1 | 0.811 | 10 | 39.53 | No | |
| | 3.3 | 3.0 | 0.5 | 1.1 | 0.580 | 10 | 47.60 | No | |
| | 3.3 | 3.0 | 0.47 | 1.1 | 0.422 | 10 | 70.20 | Yes | |
| | 3.75 | 3.2 | 0.62 | 1.1 | 0.977 | 12 | 5.01 | No | |
| | 3.75 | 3.2 | 0.58 | 1.1 | 0.693 | 12 | 57.47 | No | |
| | 3.75 | 3.2 | 0.56 | 1.1 | 0.580 | 12 | 58.30 | No | |
| | 3.75 | 3.2 | 0.54 | 1.1 | 0.422 | 12 | 70.20 | Yes | |

**Table B2**

| Table: Pulling conditions, GOI results, and presence/absence of dislocation clusters | | | | | | | | | |
|---|---|---|---|---|---|---|---|---|---|
| | G1 °C/mm | G2 °C/mm | V mm/mIn | G1e /G1c | r(OSF) /r(Crystal) | G1*G2 °C²/mm² | GOI % | Dislocation Clusters Present? | Applicable to Claims |
| Table 2 | 1.5 | 1.33 | 0.25 | 1.15 | 0.811 | 2 | 60.12 | No | ○ |
| | 1.5 | 1.33 | 0.24 | 1.15 | 0.788 | 2 | 60.92 | No | ○ |
| | 1.5 | 1.33 | 0.23 | 1.15 | 0.606 | 2 | 78.79 | No | ○ |
| | 1.5 | 1.33 | 0.22 | 1.15 | 0.520 | 2 | 82.30 | No | ○ |
| | 1.5 | 1.33 | 0.21 | 1.15 | 0.470 | 2 | 87.63 | Yes | |
| | 2.0 | 2.0 | 0.34 | 1.15 | 0.962 | 4 | 27.53 | No | |
| | 2.0 | 2.0 | 0.33 | 1.15 | 0.782 | 4 | 61.00 | No | ○ |
| | 2.0 | 2.0 | 0.32 | 1.15 | 0.708 | 4 | 62.47 | No | ○ |
| | 2.0 | 2.0 | 0.31 | 1.15 | 0.606 | 4 | 75.51 | No. | ○ |
| | 2.0 | 2.0 | 0.3 | 1.15 | 0.520 | 4 | 82.20 | No | ○ |
| | 2.0 | 2.0 | 0.28 | 1.15 | 0.470 | 4 | 84.60 | Yes | |
| | 2.5 | 2.4 | 0.41 | 1.15 | 0.854 | 6 | 36.77 | No | |
| | 2.5 | 2.4 | .0.4 | 1.15 | 0.708 | 6 | 60.22 | No | ○ |
| | 2.5 | 2.4 | 0.39 | 1.15 | 0.606 | 6 | 74.70 | No | ○ |
| | 2.5 | 2.4 | 0.38 | 1.15 | 0.520 | 6 | 82.20 | No | ○ |
| | 2.5 | 2.4 | 0.37 | 1.15 | 0.470 | 6 | 83.50 | Yes | |
| | 2.5 | 2.4 | 0.36 | 1.15 | 0.402 | 6 | 86.40 | Yes | |
| | 3.2 | 2.5 | 0.53 | 1.15 | 0.911 | 8 | 23.17 | No | |
| | 3.2 | 2.5 | 0.51 | 1.15 | 0.708 | 8 | 60.22 | No | ○ |
| | 3.2 | 2.5 | 0.5 | 1.15 | 0.606 | 8 | 74.44 | No | ○ |
| | 3.2 | 2.5 | 0.48 | 1.15 | 0.520 | 8 | 81.30 | No | ○ |
| | 3.2 | 2.5 | 0.46 | 1.15 | 0.470 | 8 | 87.30 | Yes | |
| | 3.2 | 2.5 | 0.44 | 1.15 | 0.402 | 8 | 89.90 | Yes | |
| | 3.3 | 3.0 | 0.55 | 1.15 | 0.911 | 10 | 21.03 | No | |
| | 3.3 | 3.0 | 0.52 | 1.15 | 0.606 | 10 | 74.35 | No | ○ |
| | 3.75 | 3.2 | 0.62 | 1.15 | 0.854 | 12 | 32.52 | No | |
| | 3.75 | 3.2 | 0.6 | 1.15 | 0.788 | 12 | 44.45 | No | |
| | 3.75 | 3.2 | 0.58 | 1.15 | 0.606 | 12 | 74.35 | No | ○ |
| | 3.75 | 3.2 | 0.56 | 1.15 | 0.520 | 12 | 76.60 | No | ○ |
| | 3.75 | 3.2 | 0.54 | 1.15 | 0.470 | 12 | 79.90 | Yes | |
| | 3.75 | 3.2 | 0.52 | 1.15 | 0.402 | 12 | 92.30 | Yes | |
| | 4.0 | 3.5 | 0.68 | 1.15 | 0.962 | 14 | 8.86 | No | |
| | 4.0 | 3.5 | 0.65 | 1.15 | 0.854 | 14 | 31.11 | No | |
| | 4.0 | 3.5 | 0.62 | 1.15 | 0.606 | 14 | 74.30 | No | ○ |

**Table 3**

| Table: Puling conditions, GOI results, and presence/absence of dislocation clusters | | | | | | | | | |
|---|---|---|---|---|---|---|---|---|---|
| | G1 °C/mm | G2 °C/mm | V mm/min | G1e /G1c | r(OSF) /r(Crystal) | G1*G2 °C²/mm² | GOI % | Dislocation Clusters Present? | Applicable to Claims |
| Table 3 | 1.5 | 1.33 | 0.25 | 1.2 | 0.828 | 2 | 61.65 | No | ○ |
| | 1.5 | 1.33 | 0.24 | 1.2 | 0.716 | 2 | 71.84 | No | ○ |
| | 2.0 | 2.0 | 0.34 | 1.2 | 0.874 | 4 | 43.60 | No | |
| | 2.0 | 2.0 | 0.33 | 1.2 | 0.828 | 4 | 60.20 | No | ○ |
| | 2.0 | 2.0 | 0.32 | 1.2 | 0.716 | 4 | 63.66 | No | ○ |
| | 2.0 | 2.0 | 0.31 | 1.2 | 0.644 | 4 | 71.82 | No | ○ |
| | 3.0 | 2.0 | 0.5 | 1.2 | 0.828 | 6 | 43.30 | No | |
| | 3.0 | 2.0 | 0.48 | 1.2 | 0.716 | 6 | 60.48 | No | ○ |
| | 3.0 | 2.0 | 0.47 | 1.2 | 0.644 | 6 | 69.96 | No | ○ |
| | 3.0 | 2.0 | 0.45 | 1.2 | 0.521 | 6 | 72.45 | No | ○ |
| | 3.0 | 2.0 | 0.43 | 1.2 | 0.481 | 6 | 78.80 | Yes | |
| | 3.2 | 2.5 | 0.57 | 1.2 | 0.989 | 8 | 15.25 | No | |
| | 3.2 | 2.5 | 0.55 | 1.2 | 0.915 | 8 | 25.76 | No | |
| | 3.2 | 2.5 | 0.53 | 1.2 | 0.828 | 8 | 40.24 | No | |
| | 3.2 | 2.5 | 0.51 | 1.2 | 0.644 | 8 | 69.20 | No | ○ |
| | 3.3 | 3.0 | 0.58 | 1.2 | 0.953 | 10 | 15.11 | No | |
| | 3.3 | 3.0 | 0.56 | 1.2 | 0.874 | 10 | 30.58 | No | |
| | 3.3 | 3.0 | 0.54 | 1.2 | 0.776 | 10 | 48.09 | No | |
| | 3.3 | 3.0 | 0.52 | 1.2 | 0.644 | 10 | 68.86 | No | ○ |
| | 3.3 | 3.0 | 0.5 | 1.2 | 0.521 | 10 | 70.30 | No | ○ |
| | 3.3 | 3.0 | 0.48 | 1.2 | 0.481 | 10 | 76.90 | Yes | |
| | 3.3 | 3.0 | 0.46 | 1.2 | 0.437 | 10 | 82.43 | Yes | |
| | 3.75 | 3.2 | 0.65 | 1.2 | 0.915 | 12 | 21.13 | No | |
| | 3.75 | 3.2 | 0.63 | 1.2 | 0.828 | 12 | 37.41 | No | |
| | 3.75 | 3.2 | 0.61 | 1.2 | 0.776 | 12 | 47.37 | No | |
| | 3.75 | 3.2 | 0.59 | 1.2 | 0.644 | 12 | 68.69 | No | ○ |
| | 3.75 | 3.2 | 0.57 | 1.2 | 0.521 | 12 | 70.10 | No | ○ |
| | 3.75 | 3.2 | 0.57 | 1.2 | 0.481 | 12 | 75.80 | Yes | |
| | 3.75 | 3.2 | 0.57 | 1.2 | 0.437 | 12 | 81.34 | Yes | |
| | 4.0 | 3.5 | 0.7 | 1.2 | 0.953 | 14 | 11.43 | No | |
| | 4.0 | 3.5 | 0.68 | 1.2 | 0.874 | 14 | 28.19 | No | |
| | 4.0 | 3.5 | 0.66 | 1.2 | 0.776 | 14 | 46.93 | No | |
| | 4.0 | 3.5 | 0.64 | 1.2 | 0.716 | 14 | 57.60 | No | |

**Table B4**

| Table: Puling conditions, GOI results, and presence/absence of dislocation clusters | | | | | | | | | |
|---|---|---|---|---|---|---|---|---|---|
| | G1 °C/mm | G2 °Gmm | V mm/min | G1e /G1c | r(OSF) /r(Crystal) | G1*G2 °C²/mm² | GOI % | Dislocation Clusters Present? | Applicable to Claims |
| Table 4 | 1.5 | 1.33 | 0.26 | 1.25 | 0.850 | 2 | 63.55 | No | ○ |
| | 1.5 | 1.33 | 0.25 | 1.25 | 0.768 | 2 | 70.34 | No | ○ |
| | 1.5 | 1.33 | 0.24 | 1.25 | 0.691 | 2 | 75.62 | No | ○ |
| | 1.5 | 1.33 | 0.23 | 1.25 | 0.611 | 2 | 79.90 | No | ○ |
| | 1.5 | 1.33 | 0.22 | 1.25 | 0.522 | 2 | 86.80 | No | ○ |
| | 1.5 | 1.33 | 0.2 | 1.25 | 0.493 | 2 | 90.41 | Yes | |
| | 2.0 | 2.0 | 0.37 | 1.25 | 0.977 | 4 | 53.68 | No | |
| | 2.0 | 2.0 | 0.35 | 1.25 | 0.885 | 4 | 44.96 | No | |
| | 2.0 | 2.0 | 0.34 | 1.25 | 0.811 | 4 | 66.62 | No | ○ |
| | 2.0 | 2.0 | 0.33 | 1.25 | 0.720 | 4 | 64.45 | No | ○ |
| | 3.0 | 2.0 | 0.55 | 1.25 | 0.949 | 6 | 27.57 | No | |
| | 3.0 | 2.0 | 0.53 | 1.25 | 0.885 | 6 | 37.15 | No | |
| | 3.0 | 2.0 | 0.51 | 1.25 | 0.811 | 6 | 48.16 | No | |
| | 3.0 | 2.0 | 0.49 | 1.25 | 0.720 | 6 | 60.58 | No | ○ |
| | 3.0 | 2.0 | 0.47 | 1.25 | 0.691 | 6 | 68.20 | No | ○ |
| | 3.0 | .2.0 | 0.45 | 1.25 | 0.611 | 6 | 73.61 | No | ○ |
| | 3.0 | 2.0 | 0.43 | 1.25 | 0.522 | 6 | 79.91 | No | ○ |
| | 3.0 | 2.0 | 0.42 | 1.25 | 0.493 | 6 | 84.30 | Yes | |
| | 3.0 | 2.0 | 0.4 | 1.25 | 0.421 | 6 | 88.89 | Yes | |
| | 3.2 | 2.5 | 0.59 | 1.25 | 0.977 | 8 | 18.08 | No | |
| | 3.2 | 2.5 | 0.57 | 1.25 | 0.918 | 8 | 27.29 | No | |
| | 3.2 | 2.5 | 0.55 | 1.25 | 0.850 | 8 | 38.69 | No | |
| | 3.2 | 2.5 | 0.53 | 1.25 | 0.768, | 8 | 51.89 | No | |
| | 3.2 | 2.5 | 0.52 | 1.25 | 0.720 | 8 | 62.31 | No | ○ |
| | 3.2 | 2.5 | 0.48 | 1.25 | 0.691 | 8 | 69.25 | No | ○ |
| | 3.2 | 2.5 | 0.47 | 1.25 | 0.611 | 8 | 74.56 | No | ○ |
| | 3.2 | 2.5 | 0.45 | 1.25 | 0.522 | 8 | 84.36 | No | ○ |
| | 3.2 | 2.5 | 0.43 | 1.25 | 0.493 | 8 | 89.72 | Yes | |
| | 3.2 | 2.5 | 0.41 | 1.25 | 0.421 | 8 | 91. No | Yes | |
| | 3.3 | 3.0 | 0.6 | 1.25 | 0.949 | 10 | 18.14 | No | |
| | 3.3 | 3.0 | 0.58 | 1.25 | 0.885 | 10 | 29.73 | No | |
| | 3.3 | 3.0 | 0.56 | 1.25 | 0.811 | 10 | 42.89 | No | |
| | 3.3 | 3.0 | 0.55 | 1.25 | 0.768 | 10 | 50.38 | No | |
| | 3.75 | 3.2 | 0.69 | 1.25 | 0.977 | 12 | 11.16 | No | |
| | 3.75 | 3.2 | 0.67 | 1.25 | 0.918 | 12 | 21.79 | No | |
| | 3.75 | 3.2 | 0.65 | 1.25 | 0.850 | 12 | 34.71 | No | |
| | 3.75 | 3.2 | 0.62 | 1.25 | 0.720 | 12 | 56.94 | No | |
| | 3.75 | 3.2 | 0.6 | 1.25 | 0.611 | 12 | 61.11 | No | ○ |
| | 3.75 | 3.2 | 0.58 | 1.25 | 0.522 | 12 | 68.93 | No | ○ |
| | 3.75 | 3.2 | 0.56 | 1.25 | 0.493 | 12 | 75.42 | Yes | |
| | 3.75 | 3.2 | 0.54 | 1.25 | 0.421 | 12 | 86.94 | Yes | |

**Table B5**

| Table 5: Pulling conditioins, GOI results, and presence/absence of dislocation clusters | | | | | | | | | |
|---|---|---|---|---|---|---|---|---|---|
| | G1 °C/mm | G2 °C/mm | V mm/min | G1e /G1c | r(OSF) /r(Crystal) | G1*G2 °C²/mm² | GOI % | Dislocation Clusters Present? | Applicable to Claims |
| Table 5 | 1.5 | 1.33 | 0.29 | 1.3 | 0.993 | 2 | 56.95 | No | |
| | 1.5 | 1.33 | 0.27 | 1.3 | 0.864 | 2 | 65.04 | No | |
| | 1.5 | 1.33 | 0.26 | 1.3 | 0.800 | 2 | 69.73 | No | |
| | 2.0 | 2.0 | 0.38 | 1.3 | 0.969 | 4 | 38.26 | No | |
| | 2.0 | 2.0 | 0.36 | 1.3 | 0.864 | 4 | 50.25 | No | |
| | 2.0 | 2.0 | 0.35 | 1.3 | 0.833 | 4 | 54.03 | No | |
| | 3.0 | 2.0 | 0.58 | 1.3 | 0.993 | 6 | 26.29 | No | |
| | 3.0 | 2.0 | 0.56 | 1.3 | 0.945 | 6 | 31.17 | No | |
| | 3.0 | 2.0 | 0.54 | 1.3 | 0.864 | 6 | 42.58 | No | |
| | 3.0 | 2.0 | 0.51 | 1.3 | 0.763 | 6 | 56.39 | No | |
| | 3.0 | 2.0 | 0.43 | 13 | 0.691 | 6 | 58.10 | No | |
| | 3.0 | 2.0 | 0.47 | 1.3 | 0.623 | 6 | 59.70 | No | |
| | 3.0 | 2.0 | 0.46 | 1.3 | 0.555 | 6 | 63.60 | Yes | |
| | 3.2 | 2.5 | 0.62 | 1.3 | 0.993 | 8 | 19.40 | No | |
| | 3.2 | 2.5 | 0.6 | 1.3 | 0.945 | 8 | 25.16 | No | |
| | 3.2 | 2.5 | 0.58 | 1.3 | 0.893 | 8 | 32.98 | No | |
| | 3.2 | 2.5 | 0.56 | 1.3 | 0.833 | 8 | 43.08 | No | |
| | 3.2 | 2.5 | 0.55 | 1.3 | 0.800 | 8 | 47.72 | No | |
| | 3.2 | 2.5 | 0.54 | 1.3 | 0.763 | 8 | 57.60 | No | |
| | 3.2 | 2.5 | 0.51 | 1.3 | 0.691 | 8 | 59.72 | No | |
| | 3.2 | 2.5 | 0.49 | 1.3 | 0.555 | 8 | 65.40 | Yes | |
| | 3.2 | 2.5 | 0.48 | 1.3 | 0.503 | 8 | 70.01 | Yes | |
| | 3.3 | 3.0 | 0.64 | 1.3 | 0.993 | 10 | 14.76 | No | |
| | 3.3 | 3.0 | 0.62 | 1.3 | 0.945 | 10 | 21.17 | No | |
| | 3.3 | 3.0 | 0.6 | 1.3 | 0.893 | 10 | 29.69 | No | |
| | 3.3 | 3.0 | 0.58 | 1.3 | 0.833 | 10 | 40.55 | No | |
| | 3.3 | 3.0 | 0.56 | 1.3 | 0.763 | 10 | 51.73 | No | |
| | 3.3 | 3.0 | 0.54 | 1.3 | 0.691 | 10 | 57.70 | No | |
| | 3.3 | 3.0 | 0.52 | 1.3 | 0.623 | 10 | 59.32 | No | |
| | 3.3 | 3.0 | 0.5 | 1.3 | 0.503 | 10 | 71.14 | Yes | |
| | 3.75 | 3.2 | 0.73 | 1.3 | 0.993 | 12 | 11.50 | No | |
| | 3.75 | 3.2 | 0.71 | 1.3 | 0.945 | 12 | 18.42 | No | |
| | 3.75 | 3.2 | 0.69 | 1.3 | 0.920 | 12 | 22.86 | No | |
| | 3.75 | 3.2 | 0.67 | 1.3 | 0.864 | 12 | 33.16 | No | |
| | 3.75 | 3.2 | 0.64 | 1.3 | 0.763 | 12 | 50.63 | No | |
| | 3.75 | 3.2 | 0.62 | 1.3 | 0.691 | 12 | 55.46 | No | |
| | 3.75 | 3.2 | 0.6 | 1.3 | 0.623 | 12 | 59.65 | No | |
| | 3.75 | 3.2 | 0.58 | 1.3- | 0.555 | 12 | 69.87 | Yes | |
| | 3.75 | 3.2 | 0.56 | 1.3 | 0.503 | 12 | 78.10 | Yes | |

**Table B6**

| Table 5: Pulling conditioins, GOI results, and presence/absence of dislocation clusters | | | | | | | | | |
|---|---|---|---|---|---|---|---|---|---|
| | G1 °C/mm | G2 °C/mm | V mm/min | G1e /G1c | r(OSF) /r(Crystal) | G1*G2 °C²/mm² | GOI % | Dislocation Clustars Present? | Applicable to Claims |
| Table 6 | 1.5 | 1.3 | 0.31 | 1.4 | 0.977 | 2 | 60.12 | No | |
| | 1.5 | 1.3 | 0.28 | 1.4 | 0.859 | 2 | 69.33 | No | |
| | 2.0 | 2.0 | 0.41 | 1.4 | 0.977 | 4 | 40.99 | No | |
| | 2.0 | 2.0 | 0.39 | 1.4 | 0.902 | 4 | 50.14 | No | |
| | 2.0 | 2.0 | 0.37 | 1.4 | 0.836 | 4 | 57.46 | No | |
| | 2.0 | 2.0 | 0.35 | 1.4 | 0.783 | 4 | 59.30 | No | |
| | 2.0 | 2.0 | 0.33 | 1.4 | 0.721 | 4 | 67.60 | No | |
| | 2.0 | 2.0 | 0.31 | 1.4 | 0.624 | 4 | 72.61 | yes | |
| | 2.0 | 2.0 | 0.29 | 1.4 | 0.562 | 4 | 80.80 | yes | |
| | 3.0 | 2.0 | 0.62 | 1.4 | 0.977 | 6 | 30.10 | No | |
| | 3.0 | 2.0 | 0.6 | 1.4 | 0.941 | 6 | 34.76 | No | |
| | 3.0 | 2.0 | 0.58 | 1.4 | 0.902 | 6 | 41.10 | No | |
| | 3.0 | 2.0 | 0.56 | 1.4 | 0.859 | 6 | 46.54 | No | |
| | 3.0 | 2.0 | 0.55 | 1.4 | 0.811 | 6 | 52.78 | No | |
| | 3.0 | 2.0 | 0.54 | 1.4 | 0.700 | 6 | 5.23 | No | |
| | 3.0 | 2.0 | 0.53 | 1.4 | 0.600 | 6 | 69.78 | yes | |
| | 3.0 | 2.0 | 0.52 | 1.4 | 0.520 | 6 | 72.30 | yes | |
| | 3.2 | 2.5 | 0.67 | 1.4 | 0.994 | 8 | 21.84 | No | |
| | 3.2 | 2.5 | 0.65 | 1.4 | 0.959 | 8 | 25.37 | No | |
| | 3.2 | 2.5 | 0.63 | 1.4 | 0.922 | 8 | 31.68 | No | |
| | 3.2 | 2.5 | 0.61 | 1.4 | 0.881 | 8 | 37.74 | No | |
| | 3.2 | 2.5 | 0.59 | 1.4 | 0.836 | 8 | 45.40 | No | |
| | 3.3 | 3.0 | 0.69 | 1.4 | 0.994 | 10 | 16.80 | No | |
| | 3.3 | 3.0 | 0.57 | 1.4 | 0.959 | 10 | 20.79 | No | |
| | 3.3 | 3.0 | 0.65 | 1.4 | 0.922 | 10 | 27.59 | No | |
| | 3.3 | 3.0 | 0.63 | 1.4 | 0.881 | 10 | 34.18 | No | |
| | 3.3 | 3.0 | 0.6 | 1.4 | 0.811 | 10 | 45.89 | No | |
| | 3.3 | 3.0 | 0.58 | 1.4 | 0.723 | 10 | 49.32 | No | |
| | 3.3 | 3.0 | 0.56 | 1.4 | 0.700 | 10 | 58.60 | No | |
| | 3.3 | 3.0 | 0.54 | 1.4 | 0.600 | 10 | 65.70 | Yes | |
| | 3.3 | 3.0 | 0.51 | 1.4 | 0.470 | 10 | 71.45 | yes | |
| | 3.75 | 3.2 | 0.78 | 1.4 | 0.994 | 12 | 13.17 | No | |
| | 3.75 | 3.2 | 0.75 | 1.4 | 0.841 | 12 | 20.97 | No | |
| | 3.75 | 3.2 | 0.72 | 1.4 | 0.881 | 12 | 31.69 | No | |
| | 3.75 | 3.2 | 0.7 | 1.4 | 0.859 | 12 | 36.01 | No | |
| | 3.75 | 3.2 | 0.68 | 1.4 | 0.811 | 12 | 44.05 | No | |
| | 3.75 | 3.2 | 0.66 | 1.4 | 0.723 | 12 | 50.28 | yes | |
| | 3.75 | 3.2 | 0.64 | 1.4 | 0.520 | 12 | 66.67 | yes | |
| | 3.75 | 3.2 | 0.62 | 1.4 | 0.470 | 12 | 72.58 | yes | |

Fig. 3(A) through Fig. 3(F) show, for Table B1 through Table B6 respectively, the ratio of the OSF ring inner diameter to the crystal diameter, and the GOI results and the presence or absence of dislocation clusters resulting from the G1xG2 condition. It was found that in order to obtain crystals with a GOI C mode yield of 60% or higher and without dislocations, it is sufficient to control the ratio of the OSF ring inner diameter to the crystal diameter, G1xG2, and G1_{edge}/G1_{center}. It was clarified that the condition range is "1.15 ≤ (G1_{edge}/G1_{center}) ≤ 1.25", and moreover "0.5 < (OSF ring inner diameter/crystal diameter) < 1.06 x (G1x G2)^{-0.2}" (where the units for G1 and G2 are "°C/mm").

### INDUSTRIAL APPLICABILITY

By means of the method or equipment of this invention, silicon single crystal wafers having a constant defect free zone can be reliably produced, stably and at low cost. Consequently the overall cost of semiconductor production processes can be reduced, and the economic benefits can be enhanced.

Also, by means of this invention a method enabling the production of crystals with an intermixing of (1) a void defect zone, (II) an OSF ring zone, and (III) a perfectly crystalline (defect free) zone, having a satisfactory GOI yield and without the occurrence of dislocation clusters, and enabling the production of device wafers suitable for efficient manufacturing.

## Claims

1. A method for producing a silicon single crystal ingot by the Czochralski method, **characterized in that**
by adjusting parameters during pulling of the silicon single crystal ingot, and performing pulling of "a silicon single crystal ingot containing a perfectly crystalline part" such that an OSF ring appears at a prescribed position in the silicon single crystal ingot, a production efficiency of "a perfectly crystalline part of the silicon single crystal ingot" and/or of "a part of the silicon single crystal ingot which can be used as wafers" is improved.

2. A method for producing a silicon single crystal ingot by the Czochralski method, **characterized in that**
Gₒᵤₜₑᵣ/G_{center}, which is a ratio of values at a crystal outer edge and at a crystal center of an average value G of a temperature gradient in the crystal in a pulling axis direction, within a temperature range from a silicon melting point to 1350°C, is between 1.10 and 1.50.

3. The silicon single crystal ingot production method according to claim 2, **characterized in that** the silicon single crystal ingot production is performed while adjusting a distance between a silicon melt and a heat-shield member installed in a Czochralski-method silicon single crystal production equipment.

4. The silicon single crystal ingot production method according to claim 2 or claim 3, **characterized in that**, when producing the silicon single crystal ingot, a pulling speed of the silicon single crystal ingot is changed.

5. A silicon single crystal wafer, obtained from the silicon single crystal ingot of any one of claims 2 through 4, wherein there exists an OSF ring an inner diameter of which is 70% or less of an overall diameter, and in which there exists, surrounding the OSF ring, a defect free zone occupying 50% or more of a total surface area (on one side). ;

6. A silicon single crystal wafer, obtained from the silicon single crystal ingot of any one of claims 2 through 4, wherein there exists an OSF ring an inner diameter of which is 50% or less of an overall diameter, and in which there exists, surrounding the OSF ring, a defect free zone occupying 75% or more of a total surface area (on one side).

7. A silicon ingot, pulled by a CZ method under conditions satisfying the following (1) and (2):
(1) 1.15 ≤ (G1_{edge}/G1_{center}) ≤ 1.25
(2) 0.5 < (OSF ring inner diameter/crystal diameter) < 1.06 x (G1_{center} x G2_{center})^{-0.2}

8. A silicon wafer, cut from the silicon ingot of claim 7, **characterized in that** the inner diameter of the OSF ring is at least 1/2 the inner diameter of the wafer.

9. A method of producing a silicon ingot, **characterized in that** the silicon ingot is pulled by the CZ method under conditions satisfying the following (1) and (2):
(1) 1.15 ≤ (G1_{edge}/G1_{center}) ≤ 1.25
(2) 0.5 < (OSF ring inner diameter/crystal diameter) < 1.06 x (G1_{center} x G2_{center})^{-0.2}

10. A silicon wafer for non-annealing, cut from a silicon ingot produced by the CZ method, **characterized in that** an inner diameter of an OSF ring is at least 1/2 a wafer inner diameter.

11. The silicon wafer for non-annealing according to claim 10, **characterized in that** the silicon ingot is produced by pulling under conditions such that "1.15 ≤ (G1_{edge}/G1_{center}) ≤ 1.25".

12. In a silicon wafer cut from a silicon ingot produced by the CZ method, a method to reduce a density of void defects existing on the inside of an OSF ring by expanding an inner diameter of the OSF ring.

13. In a silicon wafer cut from a silicon ingot produced by the CZ method, a method to improve a gate oxide integrity in an area on the inside of an OSF ring by controlling a ratio of an OSF ring inner diameter to a crystal diameter, G1xG2, and G1_{edge}/G1_{center}.
